# FASCICULE DE BREVET EUROPEEN

(11) **EP 1 344 863 B1**
(45) Date de publication et mention de la délivrance du brevet: **03.11.2004**
(21) Numéro de dépôt: 03356040.0
(22) Date de dépôt: 07.03.2003
(51) Int. Cl.: D06F 75/38

(54) **Semelle de fer a surface durcie et revêtue**
Bügeleisensohle mit gehärteter und beschichteter Oberfläche
Ironing sole plate with hardened and coated surface

(30) Priorité: 13.03.2002 FR 0203124
(43) Date de publication de la demande: 17.09.2003
(73) Titulaire: Rowenta Werke GmbH, 63067 Offenbach (DE)
(72) Inventeur: Lukas, Andrea, 63075 Offenbach (DE); Hahn, Matthias, 60599 Frankfurt (DE)
(74) Mandataire: Kiehl, Hubert

(56) Documents cités:
- EP-A- 0 640 714
- FR-A- 2 803 310
- US-A- 5 943 799

## Description

La présente invention concerne les semelles de fers à repasser.

On sait que les semelles de fer à repasser doivent présenter une surface de repassage ayant un bon glissement sur les étoffes, mais doivent résister aussi aux agressions provoquées par un nettoyage trop vigoureux ou aux frottements sur les objets durs des vêtements tels que les fermetures, les agrafes ou les boutons.

Pour résister à ces agressions susceptibles de provoquer des rayures qui diminuent les performances de glissement, on a cherché à durcir la surface de repassage.

Le brevet FR2581402 décrit ainsi une semelle en aluminium émaillé. Mais l'émaillage met en oeuvre des moyens matériels de production importants et coûteux.

On connaît aussi les surfaces durcies par un traitement mécanique, par exemple par un grenaillage, ou un micro billage comme décrit dans le brevet FR2803310, mais ce traitement peut être insuffisant pour résister aux agressions les plus fortes.

Un autre procédé de durcissement consiste à déposer sur la surface un revêtement dur par un procédé sol gel, comme décrit dans le brevet EP0640714. Un tel revêtement est fin, très résistant par lui même, et économique à produire. Cependant le support métallique du revêtement étant ductile, il peut être enfoncé et se détériorer.

Le brevet WO9813544 décrit un fer dont la semelle en aluminium comporte un revêtement anti-friction contenant un polymère inorganique. Le revêtement anti-friction est déposé sur un revêtement dur intermédiaire plus dur que l'aluminium. Mais le revêtement intermédiaire est un facteur de coût important.

L'invention qui suit a pour objet une semelle fer à repasser améliorée par le dépôt d'un revêtement dur résistant à la rayure sur la surface de repassage, et n'ayant pas les inconvénients cités.

L'objet de l'invention est atteint par une semelle métallique de fer à repasser traitée en surface, du côté en contact avec les étoffes, par un traitement mécanique d'écrouissage, remarquable en ce que ladite surface de repassage est, en outre, recouverte par un revêtement dur et résistant aux rayures.

Le métal constituant la semelle, généralement de l'aluminium ou de l'acier inoxydable, est relativement tendre. Un revêtement dur et fin posé sur ce support ne résiste pas au choc. Le revêtement est enfoncé dans le métal qui se déforme et garde une trace d'impact. De manière originale selon l'invention, grâce au traitement mécanique d'écrouissage préalable la semelle résiste à un enfoncement de la surface par un choc du fer à repasser sur une partie dure et saillante, ce qui permet au revêtement déposé en surface de résister sans s'écailler.

De préférence le traitement mécanique d'écrouissage est un micro billage ou un grenaillage.

Le traitement est conduit pour ne pas être un simple nettoyage de la surface mais pour la modifier en profondeur sans effet abrasif notable.

Les chocs multiples des billes ou de la grenaille sur la surface métallique en augmentent la dureté par l'écrouissage qu'ils provoquent. Les impacts étant multiples et rapprochés ne nuisent pas à la régularité de la surface qui prend un aspect satiné.

Le revêtement déposé sur la surface peut être un revêtement électrolytique tel qu'un chromage dur, ou un dépôt chimique d'un métal, ou un dépôt plasma, ou un dépôt obtenu par vaporisation sous vide ou tout autre dépôt procurant un revêtement améliorant la surface de repassage.

Dans une version le revêtement dur résistant aux rayures est un dépôt chimique de nickel.

Avantageusement, la semelle revêtue de nickel est portée à une température de l'ordre de 230°C pendant plusieurs heures.

Ce traitement thermique à une température inférieure à la température de recuit de la semelle produit un durcissement du revêtement.

Dans une autre version, le revêtement dur résistant aux rayures est une couche céramique obtenue par un procédé de dépôt en phase vapeur dit PVD.

Le procédé PVD permet d'obtenir une grande variété de dépôts. Outre une simple métallisation par exemple par le nickel ou le chrome, les dépôts les plus connus appropriés aux semelles de fer sont composés de nitrure ou carbonitrure de titane, de nitrure d'aluminium et de titane, de nitrure de chrome ou de zirconium.

De préférence le dépôt céramique est une couche de nitrure de chrome.

Ce dépôt, largement assez dur pour l'utilisation sur une surface de repassage, présente une très bonne résistance aux agents chimiques, à l'abrasion, moins de rugosités que le nitrure de titane, et un bon coefficient de frottement.

De préférence le revêtement dur résistant aux rayures est un revêtement comprenant une structure chimique inorganique déposée par un procédé sol gel.

De nombreuses formules connues, par exemple par les brevets de sociétés comme Datec ou INM ou Protavic, permettent d'obtenir un revêtement résistant aux rayures sur une pièce métallique par un procédé sol gel. Ce procédé économique permet de produire des revêtements durs et très adhérents dont la structure est basée sur un réseau comportant des liaisons inorganiques minérales. Les revêtements résistent à la rayure, et présentent une peau lisse permettant un bon glissement sur les étoffes. Le procédé comporte généralement une phase de mise en solution d'un précurseur organo-métallique, une phase d'hydrolyse, et après étalement sur la surface à recouvrir, une phase de cuisson qui peut être à relativement basse température.

De préférence le procédé sol gel est choisi pour obtenir le revêtement dur et résistant aux rayures sur la semelle avec des températures inférieures à la température de recuit du métal sous jacent et préserve la dureté de la surface écrouie.

Une température trop élevée, voisine ou supérieure à la température de recuit relâcherait les contraintes internes du métal façonné et pourrait entraîner des déformations de la semelle. En outre, une température trop élevée entraînerait un grossissement des grains métalliques et diminuerait la dureté en supprimant l'écrouissage.

Pour les semelles en aluminium, suivant les alliages, les températures de recuit s'échelonnent de 325 à plus de 400°C. Pour obtenir le revêtement résistant, on choisit un procédé qui ne nécessite pas de très hautes températures de cuisson, par exemple celui décrit dans le brevet US5644014. Les semelles en acier inoxydable, sont recuites à des températures plus élevées, ce qui augmente les possibilités de choix des procédés et des revêtements obtenues.

De préférence le métal constituant la semelle est un acier inoxydable ou un alliage d'aluminium.

L'invention sera mieux comprise au vu de l'exemple qui suit et des dessins annexés.

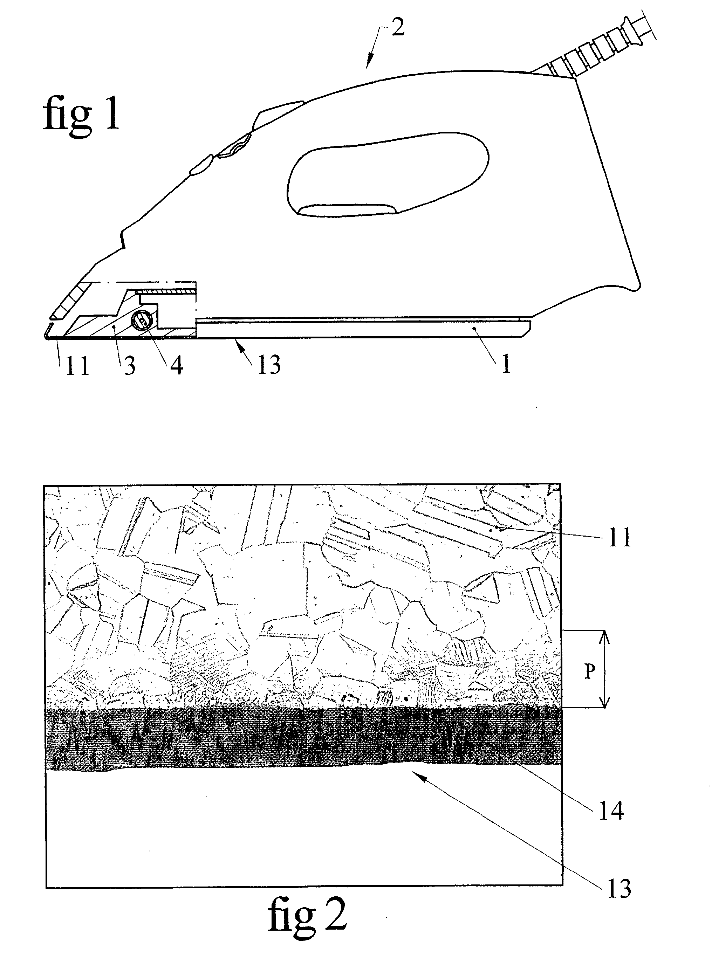

La figure 1 représente une vue de côté en coupe partielle longitudinale d'un fer équipé d'une semelle selon l'invention.

La figure 2 est une coupe micrographique de la semelle du fer de la figure 1 au voisinage de la surface de repassage.

Dans une réalisation préférentielle visible sur les figures, la semelle 1 d'un fer à repasser 2 est essentiellement composée d'une tôle d'acier inoxydable 11 dont l'épaisseur peut être comprise entre 0,4 et 1,5 mm. Elle est chauffée par un bloc chauffant 3 en aluminium équipé d'un élément chauffant 4 surmoulé.

La tôle en acier inoxydable 11 est recouverte sur la surface de repassage 13 par un revêtement dur et résistant à la rayure 14.

Le revêtement 14 adhère fortement à la tôle 11 sur sa surface, laquelle a préalablement reçu un traitement mécanique de micro billage dit de shot peening, analogue à celui décrit dans le brevet FR2803310, comportant la projection sur la surface de particules essentiellement non abrasives.

La structure de la tôle 11 est modifiée par le traitement mécanique sur une profondeur P de préférence comprise entre 25 et 35 microns à partir de la surface, ce qui en augmente sensiblement la résistance et la dureté.

De préférence la surface de la tôle 11 recouverte par le revêtement 14 présente des grains déformés par compression perpendiculaire à la surface, le nombre de dislocations métalliques par unité de volume étant supérieur de 40% à celle du métal au coeur de la tôle 11.

De préférence la dureté Vickers de la surface de la tôle 11 est supérieure d'au moins 25% à la dureté Vickers mesurée au coeur de la tôle 11.

Selon un premier mode de réalisation, le revêtement 14 a une structure de base inorganique comportant des liaisons chimiques en chaîne, que des métaux tels que le silicium, le zirconium, le titane, l'aluminium par exemple, peuvent produire principalement avec l'oxygène.

La réalisation du revêtement est de préférence conforme à la description du brevet US5644014. En effet les revêtements pouvant être produits par ces moyens ont des qualités intéressantes pour une semelle de fer. En particulier ils sont mécaniquement plus résistants à la rayure que les métaux qu'ils recouvrent. Anti-adhésifs ils facilitent le glissement du fer sur les étoffes.

De plus les températures de cuisson sont relativement basses, de l'ordre de 90 à 350°C, de préférence autour de 180°C, ce qui évite de recuire la tôle 11 car le recuit aurait relâché les contraintes internes du métal façonné, préserve la taille des grains métalliques et l'écrouissage, ainsi que la forme de la pièce.

De ce fait, le revêtement 14 peut être fin, par exemple d'épaisseur inférieure à 10 microns. Un choc sur ce revêtement est transmis au métal écroui qui résiste. Le revêtement n'est alors pas déformé et ne se brise pas.

En outre, le revêtement obtenu est transparent, ce qui préserve l'aspect métallique que donne la tôle en acier inoxydable.

Selon un autre mode de réalisation particulièrement adéquat en combinaison avec l'écrouissage extérieur de la tôle 11, le revêtement 14 est du nitrure de chrome déposé par un procédé « Physical Vapor Deposition » dit PVD. Le nitrure de chrome présente une dureté de l'ordre de trois fois celle de l'acier inoxydable. Après durcissement mécanique, la semelle du fer est placée dans une enceinte basse pression. Des ions produits par le bombardement électronique d'une ou plusieurs cibles en matériau conducteur, de préférence en chrome, sont transportés sous forme gazeuse ionisée sur la surface de la semelle où ils se condensent. Le long du parcours, les ions peuvent réagir avec le gaz raréfié de l'enceinte, de préférence de l'azote, et se combiner, pour donner de préférence un nitrure de chrome très dur sur la semelle. Le procédé ne provoquant pas d'échauffement, ne détruit pas l'écrouissage de la semelle.

On peut revêtir la semelle écrouie par d'autres dépôts PVD de métaux purs ou alliés, mais de préférence on choisit parmi les composés céramiques tels que les nitrures de chrome, de titane, de zirconium, de zirconium et d'aluminium, de carbo nitrure de titane dont les duretés sont voisines ou supérieures à celle du nitrure de chrome.

Une couche de nitrure très dure, dont l'épaisseur est de l'ordre de 1 à 5 microns, est suffisante pour donner à la semelle une excellente résistance à la rayure. La couche, soutenue par un métal écroui, ne se brise pas à l'occasion de contraintes ponctuelles comme il s'en produit à l'impact du fer sur une fermeture Eclair ou un bouton de vêtement.

Par ces moyens on obtient une semelle de fer à repasser glissant bien au repassage et peu sensible aux rayures.

## Revendications

1. Semelle métallique 1 de fer à repasser traitée en surface du côté (13) en contact avec les étoffes, par un traitement mécanique d'écrouissage, **caractérisée en ce que** ladite surface de repassage (13) traitée par ledit traitement mécanique est recouverte par un revêtement dur (14) et résistant aux rayures.

2. Semelle selon la revendication 1 **caractérisée en ce que** le traitement mécanique est un micro billage ou un grenaillage non abrasif.

3. Semelle selon la revendication 2 **caractérisée en ce que** la surface métallique recouverte par le revêtement (14) présente des grains déformés par compression perpendiculaire à la surface, le nombre de dislocations métalliques par unité de volume étant supérieur de 40% à celle du coeur du métal (11).

4. Semelle selon la revendication 2 **caractérisée en ce que** la surface métallique est modifiée par le traitement mécanique sur une profondeur (P) comprise entre 25 et 35 microns.

5. Semelle selon la revendication 1 **caractérisée en ce que** le revêtement dur résistant aux rayures (14) est déposé par un procédé sol gel.

6. Semelle selon la revendication 5 **caractérisée en ce que** le revêtement (14) dur et résistant aux rayures sur la semelle (1) est obtenu par un procédé sol gel, conduit à des températures inférieures à la température de recuit du métal sous jacent (11), qui préserve la dureté et la forme de la surface écrouie

7. Semelle selon la revendication 6 **caractérisée en ce que** le revêtement (14) est d'épaisseur inférieure à 10 microns.

8. Semelle selon la revendication 6 **caractérisée en ce que** le revêtement (14) est transparent.

9. Semelle selon la revendication 1 **caractérisée en ce que** le revêtement dur résistant aux rayures (14) est un dépôt chimique de nickel.

10. Semelle selon la revendication 9 **caractérisée en ce que** la semelle revêtue de nickel subit un traitement thermique à une température inférieure à la température de recuit.

11. Semelle selon la revendication 1 **caractérisée en ce que** le revêtement dur résistant aux rayures est une couche céramique obtenue par un procédé de dépôt en phase vapeur dit PVD.

12. Semelle selon la revendication 11 **caractérisée en ce que** la couche céramique est une couche de nitrure de chrome.

13. Semelle selon l'une des revendications précédentes **caractérisée en ce que** le métal (11) constituant la semelle (1) est un acier inoxydable.

14. Semelle selon l'une des revendications précédentes **caractérisée en ce que** le métal (11) constituant la semelle (1) est un alliage d'aluminium.

## Patentansprüche

1. Bügeleisensohle (1) aus Metall, deren mit dem Stoff in Berührung kommende Oberfläche (13) mittels eines mechanischen Kaltformungsverfahrens behandelt worden ist, **dadurch gekennzeichnet, daß** die Bügelfläche (13) nach Durchführen der mechanischen Behandlung mit einer harten kratzfesten Beschichtung (14) versehen ist.

2. Bügeleisensohle nach Anspruch 1, **dadurch gekennzeichnet, daß** es sich bei der mechanischen Behandlung um Stahlsanden oder Kugelstrahlen ohne Schleifwirkung handelt.

3. Bügeleisensohle nach Anspruch 2, **dadurch gekennzeichnet, daß** die mit der Beschichtung (14) versehene Oberfläche aus Metall durch zur Oberfläche senkrecht gerichtetes Pressen verformte Körner aufweist, wobei die Anzahl der Metallversetzungen pro Volumeneinheit um mindestens 40% größer ist als diejenige des Innenbereichs des Metalls (11).

4. Bügeleisensohle nach Anspruch 2, **dadurch gekennzeichnet, daß** die Oberfläche aus Metall durch die mechanische Behandlung in einer Tiefe von 25 bis 35 Mikrometern verändert wird.

5. Bügeleisensohle nach Anspruch 1, **dadurch gekennzeichnet, daß** die harte kratzfeste Beschichtung (14) mittels eines Sol-Gel-Verfahrens aufgebracht wird.

6. Bügeleisensohle nach Anspruch 5, **dadurch gekennzeichnet, daß** die harte kratzfeste Beschichtung auf der Bügeleisensohle (1) durch ein das Sol-Gel-Verfahren bei Temperaturen erzielt wird, die niedriger sind als die Kaltformungstemperatur des darunter liegenden Metalls (11), die die Härte und die Form der kaltgeformten Oberfläche bewahrt.

7. Bügeleisensohle nach Anspruch 6, **dadurch gekennzeichnet, dass** die Stärke der Beschichtung (14) weniger als 10 Mikrometer beträgt.

8. Bügeleisensohle nach Anspruch 6, **dadurch gekennzeichnet, dass** die Beschichtung (14) durchsichtig ist.

9. Bügeleisensohle nach Anspruch 1, **dadurch gekennzeichnet, dass** die harte kratzfeste Beschichtung (14) aus einer chemischen Nickelabscheidung besteht.

10. Bügeleisensohle nach Anspruch 9, **dadurch gekennzeichnet, dass** die mit Nickel beschichtete Bügeleisensohle bei einer Temperatur behandelt wird, die niedriger ist als die Ausglühungstemperatur.

11. Bügeleisensohle nach Anspruch 1 **dadurch gekennzeichnet, dass** die harte kratzfeste Beschichtung aus einer mittels eines PVD-Verfahrens (physical vapour desposition) aufgebrachten Keramikschicht besteht.

12. Bügeleisensohle nach Anspruch 11, **dadurch gekennzeichnet, dass** die Keramikschicht eine Schicht aus Chromnitrid ist.

13. Bügeleisensohle nach einem der vorangehenden Ansprüche, **dadurch gekennzeichnet, dass** das die Bügeleisensohle (1) bildende Metall (11) nichtrostender Stahl ist.

14. Bügeleisensohle nach einem der vorangehenden Ansprüche, **dadurch gekennzeichnet, dass** das die Bügeleisensohle (1) bildende Metall (11) eine Aluminiumlegierung ist.

## Claims

1. A smoothing-iron metal soleplate (1) that is surface treated on its side (13) for contacting the fabric by a mechanical work-hardening treatment, the soleplate being **characterized in that** said ironing surface (13) that is treated by said mechanical treatment is coated in a hard, scratch-resistant coating (14).

2. A soleplate according to claim 1, **characterized in that** the mechanical treatment is a non-abrasive micro-beading or shot-peening treatment.

3. A soleplate according to claim 2, **characterized in that** the metal surface coated in the coating (14) presents grains deformed by compression that is perpendicular to the surface, the number of metal dislocations per unit volume being 40% greater than in the core of the metal (11).

4. A soleplate according to claim 2, **characterized in that** the metal surface is modified by the mechanical treatment over a depth (P) lying in the range 25 *µ*m to 35 *µ*m.

5. A soleplate according to claim 1, **characterized in that** the hard, scratch-resistant coating (14) is deposited by a sol gel method.

6. A soleplate according to claim 5, **characterized in that** the hard, scratch-resistant coating (14) on the soleplate (1) is obtained by a sol gel method brought to temperatures that are lower than the annealing temperature of the underlying metal (11), which preserves the hardness and the shape of the work-hardened surface.

7. A soleplate according to claim 6, **characterized in that** the coating (14) is of thickness that is less than 10 µm.

8. A soleplate according to claim 6, **characterized in that** the coating (14) is transparent.

9. A soleplate according to claim 1, **characterized in that** the hard, scratch-resistant coating (14) is a chemical deposit of nickel.

10. A soleplate according to claim 9, **characterized in that** the nickel-plated soleplate is subjected to heat treatment at a temperature that is lower than the annealing temperature.

11. A soleplate according to claim 1, **characterized in that** the hard, scratch-resistant coating is a ceramic layer obtained by a physical vapor deposition (PVD) method.

12. A soleplate according to claim 11, **characterized in that** the ceramic layer is a layer of chromium nitride.

13. A soleplate according to any preceding claim, **characterized in that** the metal (11) constituting the soleplate (1) is a stainless steel.

14. A soleplate according to any preceding claim, **characterized in that** the metal (11) constituting the soleplate (1) is an aluminum alloy.
